# EUROPEAN PATENT APPLICATION

(11) **EP 1 557 890 A1**
(43) Date of publication of application: **27.07.2005**
(21) Application number: 04001056.3
(22) Date of filing: 20.01.2004
(51) Int. Cl.: H01L 33/00

(54) **White-light LED and method for regulating the generated light color of the white-light LED**

(71) Applicant: TAIWAN OASIS TECHNOLOGY CO., LTD., Taiwan (CN)
(72) Inventor: Lee, Ming-Shun, Taoyuan Hsien Taiwan (TW); Sun, Ping-Ru, Jangshu City Jiangsi Province (CN)
(74) Representative: Patentanwälte Hauck, Graalfs, Wehnert, Döring, Siemons, Schildberg

(57) **Abstract**

A white-light light emitting diode (LED) and a method for regulating the generated light color of the LED, wherein the LED has at least one InGaN chip (30) and at least one AlGaInP chip (20). When forward bias voltages are applied on the InGaN chip (30) or AlGaInP chip (20), blue light and green-yellow light are generated and further mixed to create white light. By adjusting an external impedance value applied on the LED to regulate the forward bias voltages, pure white light is able to be derived based on the regulated brightness strength of the blue light and green-yellow light.

## Description

### 1. Field of the Invention

The present invention relates to a white-light light emitting diode (LED) and a method for regulating the generated light color of the LED, more particularly, the generated light color of the LED is able to be determined by regulating an external impedance value applied on the LED.

### 2. Description of Related Art

Development and manufacture of early light emitting diodes, despite them being of low power consumption and long use life, was hampered by them being limited by brightness and tint problems. However, with the improvement of a fabricating technique to achieve higher brightness, LEDs capable of generating white light have been developed in recent years and applied in the construction of illumination devices.

Some well-known techniques to generate white-light LEDs are listed as follow.
1. Mix the blue light emitted by an InGaN chip and the yellow light generated by YAG phosphor powder to generate white light.
2. Use the InGaN chip to excite R,G,B colors phosphor powder so as to create white light.
3. Use ultraviolet rays to excite R,G,B colors phosphor powder so as to create white light.
4. Mix the blue light supplied by an InGaN chip and the green-yellow light generated by a GaP chip to create white light.

It is noted that a common feature of the above first to third techniques is that the phosphor powder is adopted as the essential raw material for producing white light. However, the minor variations in thickness of the phosphor powder coated on the LED or the percentage error of the compound material will cause color aberration of the generated light. The produced light may thus present a slight yellow color or blue color. Even for the same batch of the LED products, the generated light color of each LED may be different from others. Thus, consistent and pure white light is difficult to acquire. Another problem is that the driving voltage for activating such LEDs must be higher than 3 volts.

For the fourth technique, the fabrication cost of the LEDs is much higher than of the first three because of the GaP chip. Further, the brightness performance is inferior to those of the previous mentioned three kinds of techniques.

An objective of the present invention is to provide a white-light light emitting diode (LED) and a method for regulating the generated light color of the LED, wherein the generated light is controlled by an external impedance applied on the LED.

To accomplish the objective, the white-light LED of the invention comprises:
a supporting base formed by a cathode terminal and at least two anode terminals, wherein a supporting platform with a cavity defined therein is formed on a top end of the cathode terminal;
an AlGaInP chip is mounted in the cavity of the supporting platform, wherein a cathode node of the AlGaInP chip is electrically connected to the cathode terminal and an anode node is connected to one of the at least two anode terminals;
at least one InGaN chip mounted in the cavity, where a cathode node of the at least one InGaN chip is electrically connected to the cathode terminal and an anode of the InGaN chip is connected to the other one of the at least two anode terminals;
a light pervious body formed on the supporting base to comprehensively seal the two chips; and
at least one resistor having a first end selectively connected to the AlGaInP chip or the at least one InGaN chip and a second end connected to a positive voltage.

Other objects, advantages and novel features of the invention will become more apparent from the following detailed description when taken in conjunction with the accompanying drawings.
In the drawings:
Fig. 1 is a plan view of a white-light light emitting diode (LED) according to a first embodiment of the present invention;
Fig. 2 is an equivalent circuit of the LED of Fig. 1;
Fig. 3 is a cross-sectional view of a white-light light emitting diode (LED) according to a second embodiment of the present invention;
Fig. 4 is a top plan view of the LED of Fig. 3;
Fig. 5 is an equivalent circuit of a white-light light emitting diode (LED) according to a third embodiment of the present invention; and
Fig. 6 is a circuit diagram showing a DC voltage is supplied on the LED of Fig. 5.

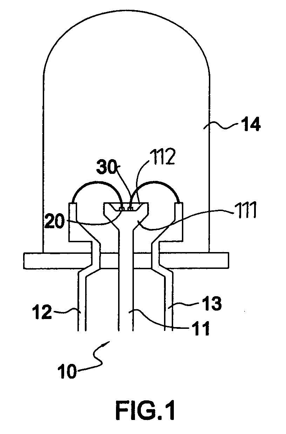

With reference to Fig. 1, a white-light light emitting diode (LED) according to a first embodiment mainly includes a metal supporting base (10), an aluminum-gallium-indium phosphide (AlGaInP) chip (20), an indium-gallium nitrides (InGaN) chip (30) and a light pervious body (14).

The supporting base (10) is formed by a cathode terminal (11) and two anode terminals (12)(13). A supporting platform (111) with a cavity (112) defined therein is formed on the top end of the cathode terminal (11).

The AlGaInP chip (20) is mounted in the cavity (112) of the supporting platform (111), wherein a cathode node of the AlGaInP chip (20) is connected to the cathode terminal (11) and an anode node is correspondingly connected to a first of the anode terminals, (12), through a bonding wire.

The InGaN chip (30) is also securely mounted in the cavity (112) via epoxy or other similar materials, where a cathode node of the InGaN chip (30) is also connected to the cathode terminal (11) and an anode of which is connected to the second anode terminal (13) through another bonding wire.

The light pervious body (14) is formed on the supporting base (10) to comprehensively seal the two chips (20) (30) and the bonding wires.

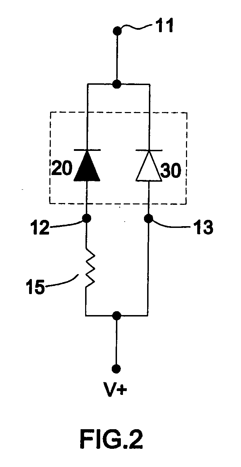

With reference to Fig. 2, the equivalent circuit of the LED of Fig. 1 is shown. In the first embodiment, an external resistor (15) is provided to connect between a positive voltage source (V+) and the anode terminal (12) that electrically connects to the AlGaInP chip (20). By properly adjusting the resistance of the external resistor (15) to change the forward bias voltage level over the AIGaInP chip (20), the green-yellow light with a desired brightness generated by AlGaInP chip (20) is able to mix with the blue light emitted from the InGaN chip (30) to derive the pure white light. Alternatively, the brightness of the InGaN chip (30) also can be changed by adjusting its forward bias through the use of an external resistor.

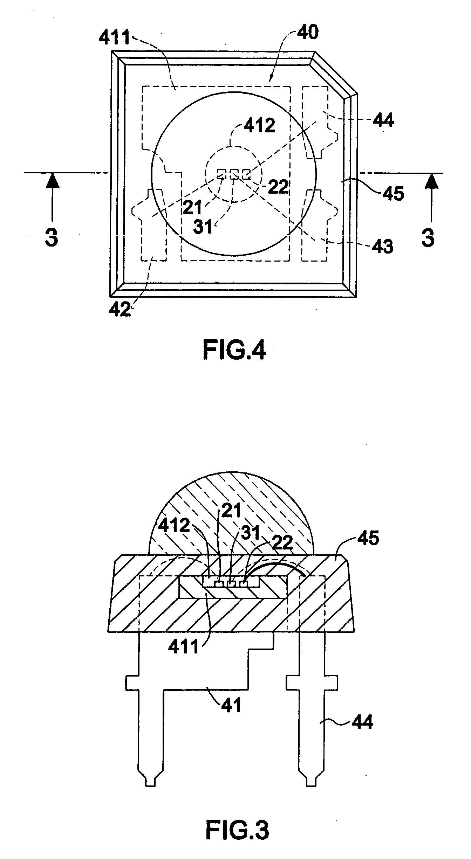

With reference to Figs. 3 and 4, a second embodiment of the LED of the present invention has a metal supporting base (40) with a cathode terminal (41) and three anode terminals (42, 43 and 44), wherein a platform (411) is integrally formed at the top of the cathode terminal (41) and a cavity (412) is defined in the platform (411).

Two AlGaInP chips (21)(22) are mounted in the cavity (412), where a cathode node of each AlGaInP chip (21)(22) is electrically connected to the cathode terminal (41), and an anode of each AlGaInP chip (21)(22) is electrically connected to a corresponding anode terminal (42)(44) via a bonded wire.

An InGaN chip (31), which is mounted in the cavity (412) and between the two AIGaInP chips (21)(22), has a cathode node and an anode respectively connected to the cathode terminal (41) and the anode terminal (43)

A light pervious body (45) is formed on the supporting base (10) to comprehensively seal the three chips (21, 22) (31) and the bonded wires.

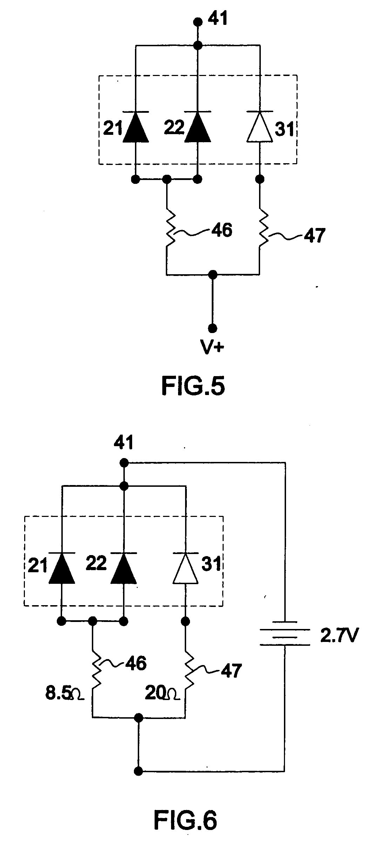

With reference to Fig. 5, the equivalent circuit of the LED of Fig. 3 is shown. A first external resistor (46) connects between a positive voltage source (V+) and a common node where the anode nodes of the two AlGaInP chips (21)(22) connect together so as to adjust the forward bias voltage level over the two chips (21)(22). A second external resistor (47) is connected between the positive voltage source (V+) and the anode terminal (43) to control the brightness of the InGaN chip (31).

With reference to Fig. 6, a 2.7 volts DC power is applied on the chips (21)(22)(31), where the preferred value of the first external resistor (46) is 8.5Ω ohm and the second external resistor is 20Ω. By simultaneously regulating the brightness of each chip (21)(22)(31), pure white light can be derived.

As shown in Figs. 3 and 4, the three chips (21)(22)(31) are arranged linearly, however, their mounting positions in the cavity (412) may be alternated in any desired form. It is noted that the amount of the chips in the cavity (412) is also variable. For example, four AlGaInP chips may be placed in a rectangular shape, and one InGaN chip is mounted at the central position of these AlGaInP chips.

As discussed above, the present invention utilizes the blue light and green-yellow light respectively generated by InGaN chip and AlGaInP chip to obtain the pure light by properly mixing the two colors. Because the AlGaInP chip is much cheaper than the GaP chip, the white light LED of the present invention is quite suitable for mass production. The external resistors are not only applied to generate the white light, but also can be used to adjust the LED to thus create a desired white-yellow light or white-blue light if necessary. Moreover, only a low operating voltage is adopted for adjusting the brightness of the chips.

It is to be understood, however, that even though numerous characteristics and advantages of the present invention have been set forth in the foregoing description, together with details of the structure and function of the invention, the disclosure is illustrative only, and changes may be made in detail, especially in matters of shape, size, and arrangement of parts within the principles of the invention to the full extent indicated by the broad general meaning of the terms in which the appended claims are expressed.

## Claims

1. A white-light light emitting diode (LED) comprising:
a supporting base (10) formed by a cathode terminal (11) and at least two anode terminals (12)(13), wherein a supporting platform (111) with a cavity (112) defined therein is formed on a top end of the cathode terminal (11);
at least one AlGaInP chip (20) mounted in the cavity (112) of the supporting platform (111), wherein a cathode node of the at least one AlGaInP chip (20) is electrically connected to the cathode terminal (11) and an anode node is connected to a first (12) of the at least two anode terminals;
an InGaN chip (30) mounted in the cavity (112), where a cathode node of the InGaN chip (30) is electrically connected to the cathode terminal (11) and an anode of the InGaN chip (30) is connected to a second (13) of the at least two anode terminals;
a light pervious body (14) formed on the supporting base (10) to comprehensively seal the two chips (20)(30); and
at least one resistor (15) having a first end selectively connected to the AIGaInP chip (20) or the at least one InGaN chip (30) and a second end connected to a positive voltage(V+).

2. The white-light LED as claimed in claim 1, wherein only one AlGaInP chip (20) and only one InGaN chip (30) are mounted in the cavity (112).

3. The white-light LED as claimed in claim 1, wherein only one InGaN chip (31) and multiple AlGaInP chips (21,22) are mounted in the cavity.

4. The white-light LED as claimed in claim 2, wherein the AlGaInP chip (20) and the InGaN (30) chip are arranged linearly.

5. The white-light LED as claimed in claim 3, wherein the AlGaInP chips (21,22) and the InGaN chip(31) are arranged linearly.

6. The white-light LED as claimed in claim 3, wherein the InGaN chip (31) is arranged in a center position among the multiple AlGaInP chips (21,22).

7. The white-light LED as claimed in claim 1, wherein the first end of the resistor (15) is connected to the anode terminal (12) to which the AlGaInP (20) chip is connected.

8. The white-light LED as claimed in claim 1, wherein the first end of the resistor (15) is connected to the anode terminal (13) to which the InGaN chip (30) is connected.

9. A method for regulating the light color of an LED having at least one AlGaInP chip (20) and at least one InGaN chip (30), the method comprising the acts of:
mixing a blue light and a green-yellow light respectively generated by the least one AlGaInP chip (20) and the at least one InGaN chip (30); and
adjusting a forward bias voltage of the least one AlGaInP chip (20) or the at least one InGaN chip (30) by controlling an external impedance value, whereby brightness of the blue-light or the green-yellow light is accordingly varied to generate a desired light color.

10. The method as claimed in claim 9, wherein the act of the external impedance value controlling is accomplished by connecting a resistor (15) between a power source (V+) and the least one AlGaInP chip (20).

11. The method as claimed in claim 9, wherein the act of the external impedance value controlling is accomplished by connecting a resistor (15) between a power source and the at least one InGaN chip (30).
